# EUROPEAN PATENT APPLICATION

(11) **EP 4 542 619 A2**
(43) Date of publication of application: **23.04.2025**
(21) Application number: 24201693.9
(22) Date of filing: 20.09.2024
(51) Int. Cl.: H01J 37/305, H01J 37/28, H01J 37/08, H01J 37/02, H01J 37/244

(54) **FOCUSED ION BEAM SYSTEM**

(30) Priority: 28.09.2023 JP 2023168346
(71) Applicant: Jeol Ltd., Akishima-shi, Tokyo 196-8558 (JP)
(72) Inventor: MIZUNO, Noriaki, Tokyo, 196-8558 (JP); SHIGEYAMA, Wataru, Tokyo, 196-8558 (JP); AOSHIMA, Makoto, Tokyo, 196-8558 (JP)
(74) Representative: Boult Wade Tennant LLP

(57) **Abstract**

There is provided a focused ion beam (FIB) system capable of preventing a film from being deposited thickly on the surface of a sample. The FIB system (100) operates to mill the sample (S) by irradiating it with an ion beam. The FIB system (100) comprises: an FIB column (20) through which the ion beam is directed at the sample (S); a nozzle (42) having a blowoff port (41) for blowing a gas against the sample (S) to deposit the film; a sample stage (30) providing mechanical support of the sample (S); a shield member (60) for impeding the flow of the gas, the shield member (60) being movable to a shield position located between the blowoff port (41) and the sample (S) supported on the stage (30), the shield member (60) being also movable to a retractive position not located therebetween; and a shield member support mechanism (70) that supports the shield member (60) so that it can move between the shield position (FIG. 5) and the retractive position (FIG. 4) of the shield member.

## Description

### BACKGROUND OF THE INVENTION

### 1. Field of the Invention

The present invention relates to a focused ion beam (FIB) system.

### 2. Description of the Related Art

In a focused ion beam (FIB) system, a sample can be milled by scanning its surface with a focused ion beam. Furthermore, in this FIB system, a film can be deposited on the surface of the sample by irradiating the sample with an electron beam or an ion beam while blowing a gas compound against and around the sample surface. With a cryo-FIB system in which a cooled sample is milled, a film can be deposited on the surface of the sample only by blowing a gas compound against the sample without any beam irradiation.

In Patent document 1, there is disclosed a focused ion beam system equipped with a gas gun for blowing a gas compound against a sample. The gas gun includes a gas tank containing a gas source as well as a gas nozzle. When a film is deposited, the gas nozzle is moved by an air cylinder from its retracted position so as to approach a height hundreds of micrometers away from the milled point on the sample. A gas seal plug is mounted in the gas tank. Gas can be blown against the sample by opening the gas seal plug.

### Citation List

### Patent Documents

Patent document 1: JP-A-2007-134520

With the above-described gas gun, if the gas tank is closed with the gas seal plug, gas remains inside the gas nozzle and leaks out through the gas nozzle. Then, the leaking gas reaches the surface of the sample. As a result, a film may be unintentionally deposited so thickly that observation and analysis using an electron microscope are adversely affected.

### SUMMARY OF THE INVENTION

One aspect of the focused ion beam system associated with the present invention is adapted to mill a sample by irradiating it with an ion beam and comprises:
an ion beam column through which the ion beam is directed at the sample;
a nozzle having a blowoff port for blowing a gas against the sample to deposit a film;
a sample stage providing mechanical support of the sample;
a shield member for impeding the flow of the gas, the shield member being movable to a shield position that is located between the blowoff port and the sample supported on the sample stage, the shield member being also movable to a retractive position not located between the blowoff port and the sample supported on the sample stage; and
a shield member support mechanism for supporting the shield member so that the shield member can move between the shield position and the retractive position of the shield member.

In this FIB system, when the nozzle is not in use, the shield member can be placed between the blowoff port and the sample. This can reduce the amount of gas reaching the sample after leaking from the nozzle. Consequently, it can be prevented that a film is deposited on the surface of the sample so thickly that observation and analysis using an electron microscope are adversely affected.

Another aspect of the focused ion beam system associated with the present invention is adapted to mill a sample by irradiating it with an ion beam and comprises:
an ion beam column through which the ion beam is directed at the sample;
a nozzle having a blowoff port for blowing a gas against the sample to deposit a film;
a sample stage providing mechanical support of the sample; and
a switching mechanism for effecting a switch between an operable state in which the blowoff port faces towards the sample and a film can be deposited and a retracted state in which the blowoff port faces away from the sample.

When the nozzle of this FIB system is not used, the FIB system can be placed in the retracted state in which the blowoff port faces away from the sample. Therefore, with this FIB system, the amount of the gas leaking out from the nozzle and reaching the sample can be reduced. Thus, it can be prevented that a film is deposited on the surface of the sample so thickly that observation and analysis using an electron microscope are adversely affected.

### BRIEF DESCRIPTION OF THE DRAWINGS

FIG. 1 is a schematic view, partly in block form, showing the configuration of a focused ion beam (FIB) system associated with one embodiment of the present invention.
FIGS. 2 and 3 are schematic cross-sectional views of a gas ejector, illustrating different modes of operation.
FIGS. 4 and 5 are schematic views similar to FIG. 1, but illustrating operations of the FIB system.
FIG. 6 is a schematic cross-sectional view similar to FIG. 3, but in which the valve is closed.
FIG. 7 is a schematic view showing a modification of the FIB system of FIG. 1.
FIGS. 8 and 9 are schematic views, partly in block form, showing the configuration of an FIB system associated with a second embodiment.
FIGS. 10 and 11 are schematic views, partly in block form, showing the configuration of an FIB system associated with a third embodiment.
FIGS. 12 and 13 are schematic views, partly in block form, showing the configuration of an FIB system associated with a fourth embodiment.
FIGS. 14 and 15 are schematic views, partly in block form, showing the configuration of an FIB system associated with a fifth embodiment.

### DETAILED DESCRIPTION OF THE INVENTION

The preferred embodiments of the present invention are hereinafter described in detail with reference to the drawings. It is to be understood that the embodiments provided below do not unduly restrict the scope and content of the present invention delineated by the appended claims and that not all the configurations described below are essential constituent components of the invention.

### 1. First Embodiment

### 1.1. Focused Ion Beam System

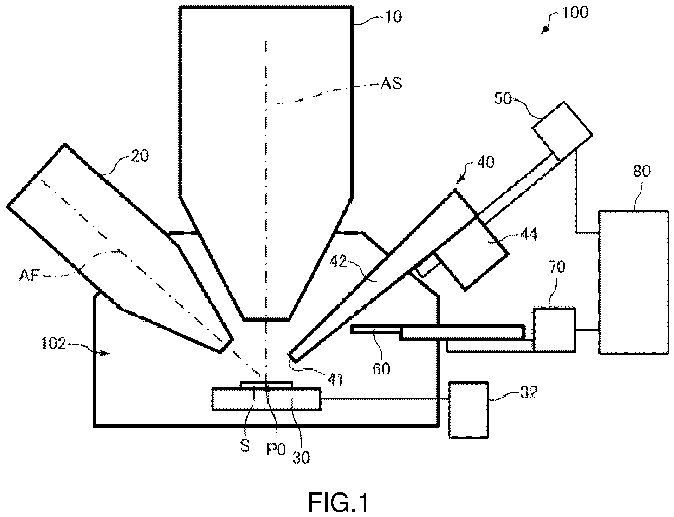

A focused ion beam (FIB) system associated with a first embodiment is first described by referring to FIG. 1, which shows the configuration of the FIB system, 100. As shown, the FIB system 100 includes an SEM (scanning electron microscope) column 10, an FIB (focused ion beam) column 20, a sample stage 30, a cooling mechanism 32, a gas ejector 40 equipped with a nozzle 42, a nozzle support mechanism 50, a shield member 60, a shield member support mechanism 70, and a controller 80. Because the FIB system 100 is equipped with the SEM column 10 and the FIB column 20, the system permits milling and observation of a sample S.

The SEM column 10 that irradiates the sample S with an electron beam operates to form and scan an electron probe. The SEM column 10 includes an electron gun for emitting the electron beam and an electron optical system that focuses the electron beam into the electron probe and scans it. The electron beam emitted from the electron gun travels along the optical axis AS of the SEM column 10 and strikes the sample S.

The FIB system 100 can produce SEM images by scanning the sample S with the electron probe and detecting electrons emanating from the sample S with an electron detector (not shown).

The FIB column 20 that operates to irradiate the sample S with an ion beam forms and scan the ion beam. The FIB column 20 includes an ion gun for emitting the ion beam and an ion optical system for focusing the ion beam and scanning the focused ion beam. The ion beam emanating from the ion gun travels along the optical axis AF of the FIB column 20 and strikes the sample S. The FIB system 100 can mill the sample S by scanning the sample S with the focused ion beam.

The sample stage 30 mechanically supports the sample S, which in turn is disposed in a sample chamber 102. The sample chamber 102 is evacuated to a vacuum or subatmospheric condition by a vacuum pump (not shown). In the FIB system 100, milling and observation of the sample S are carried out at the intersection point P0 of the optical axes AS and AF.

The sample stage 30 includes a drive mechanism for moving the sample S horizontally and vertically, as well as a tilt mechanism for tilting the sample S. For these purposes, the drive mechanism and tilt mechanism use drive sources such as electric motors. The sample stage 30 may be so configured that it can support a sample holder which can be shared between the FIB system 100 and a transmission electron microscope. That is, the sample stage 30 may support the sample S via a sample holder capable of being shared between the FIB system and the transmission electron microscope.

The cooling mechanism 32 cools the sample stage 30, resulting in cooling of the sample S. The cooling mechanism 32 includes, for example, a tube through which a gas flows and a refrigerant tank for cooling the gas. The cooling mechanism 32 cools the sample stage 30 by passing the gas cooled with the refrigerant tank filled with liquid nitrogen, for example, through the tube in thermal communication with the sample stage 30. In addition, the cooling mechanism 32 may include a refrigerant tank and thermal conductive lines that thermally connect the refrigerant tank with the sample stage 30, whereby the sample stage 30 can be cooled.

Because the FIB system 100 is equipped with the cooling mechanism 32 for cooling the sample stage 30 in this way, the system can be used as a cryo-FIB capable of milling the sample S while cooling it. Therefore, with the FIB system 100, biological samples in frozen state, battery materials, and so on can be milled and observed.

The gas ejector 40 blows a gas against the sample S to deposit a film. Where a film is deposited on the sample S at room temperature, the sample S is irradiated with an electron beam or an ion beam while blowing the gas against the sample S with the gas ejector 40. Secondary electrons emanating from the irradiated sample S decomposes the gas into the deposited film material and gas components. Consequently, the deposited film material adheres to the sample S, depositing the film. Where a film is deposited on the sample S that is being cooled, a gas is blown against the sample S without any beam irradiation. The gas adheres to the surface of the cooled sample S. Consequently, a film can be deposited.

The gas ejector 40 has the nozzle 42 and a reservoir tank 44. A gas source is housed in the reservoir tank 44, which in turn is disposed outside the sample chamber 102. The nozzle 42 is a thin, elongated cylindrical member and has a blowoff port 41 at its front end. A gas is discharged from the blowoff port 41 and blown against the sample S. When the gas is blown against the sample S, the nozzle support mechanism 50 places the blowoff port 41 close to the sample S.

The nozzle 42 is movably supported by the nozzle support mechanism 50. The whole gas ejector 40 including the nozzle 42 and the reservoir tank 44 is movably supported by the nozzle support mechanism 50. Alternatively, only the nozzle 42 may be movably supported by the nozzle support mechanism 50. For example, the nozzle support mechanism 50 is a single-axis actuator including drive sources (such as an electric motor and an air cylinder) and a power transfer member (such as a linear guide) interconnecting the drive sources and the nozzle 42. No restrictions are imposed on the structure of the nozzle support mechanism 50 as long as the nozzle 42 can be movably supported by the support mechanism 50.

The shield member 60 acts to impede the flow of gas and is made of a flat plate-like member, for example. Because the shield member 60 is located between the blowoff port 41 and the sample S, the flow of gas leaking out from the nozzle 42 and going toward the sample S can be impeded. No restrictions are placed on the shape and material of the shield member 60 as long as it can impede the flow of gas.

The shield member 60 is movably supported by the shield member support mechanism 70 that is a one-axis actuator including a motive device (such as a motor or an air cylinder) and a power transfer member (such as a linear guide) connecting together the motive device and the nozzle 42. No restrictions are imposed on the structure of the shield member support mechanism 70 as long as the shield member 60 can be movably supported by the support mechanism 70.

The controller 80 controls the nozzle support mechanism 50 and the shield member support mechanism 70 and includes a processor such as a CPU (central processing unit) or a DSP (digital signal processor) and memories (such as a RAM (random access memory) and a ROM (read only memory)). Programs and data permitting various kinds of control operations are stored in the memories. The functions of the controller 80 can be implemented by executing programs with the processor. The controller 80 includes an input device serving as a user interface for accepting a user's instructions.

### 1.2. Gas Ejector

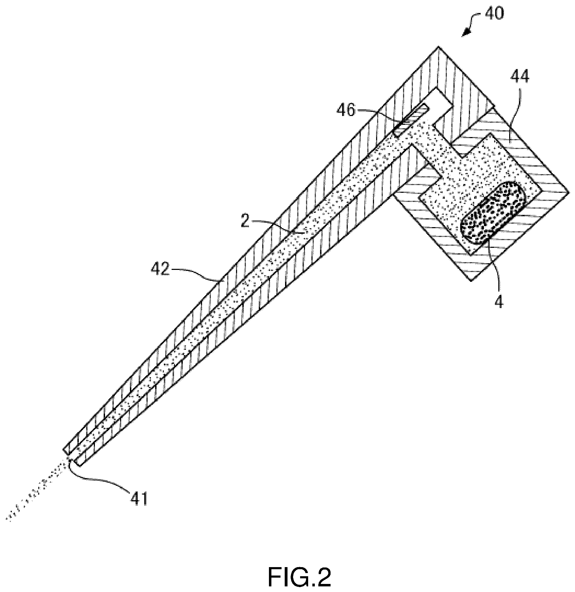

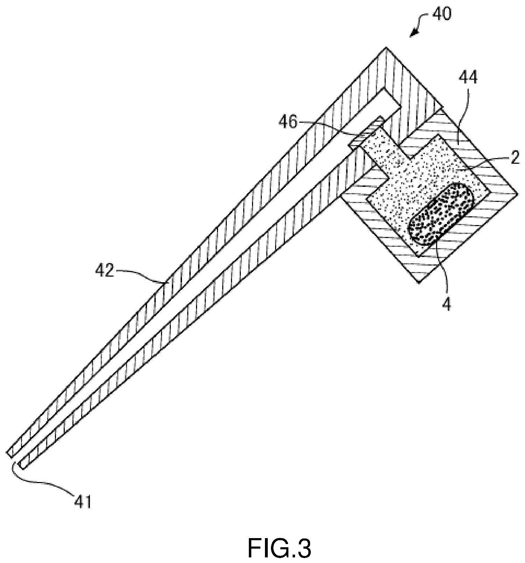

FIGS. 2 and 3 are schematic cross sections of the gas ejector 40 that includes the nozzle 42, the reservoir tank 44, and a valve 46. FIG. 2 shows a state in which the valve 46 is open. FIG. 3 shows a state in which the valve 46 is closed.

A gas source 4 in liquid or solid form is accommodated in the reservoir tank 44. Examples of the gas source 4 include carbon compounds, tungsten compounds, and platinum compounds. Gas 2 produced from the gas source 4 is supplied from the reservoir tank 44 into the nozzle 42 through the valve 46.

The valve 46 is mounted between the nozzle 42 and the reservoir tank 44. The gas 2 can be ejected from the nozzle 42 by opening the valve 46. The ejection of the gas 2 can be stopped by closing the valve 46.

The nozzle 42 is connected to the reservoir tank 44 via the valve 46. The nozzle 42 is a cylindrical member that blows the gas 2 from the blowoff port 41 against the sample S. In the FIB system 100, the use of the thin, elongated nozzle 42 makes it possible to locate the reservoir tank 44 remotely from the sample S.

### 1.3. Operation

### 1.3.1. Operation of Nozzle and Shield Member

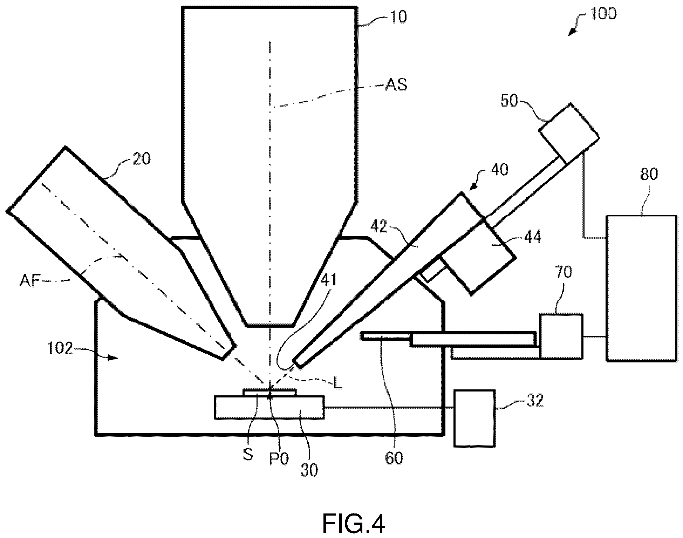

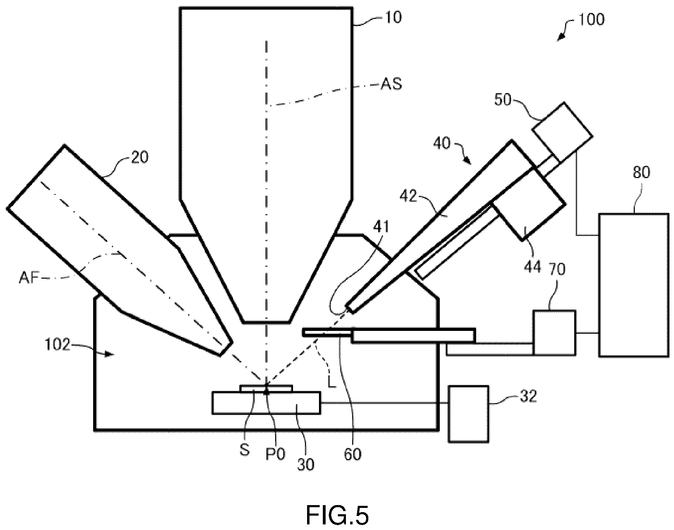

FIGS. 4 and 5 illustrate the operation of the focused ion beam (FIB) system 100. The nozzle 42 can move between a deposition position shown in FIG. 4 and the retractive position of the nozzle shown in FIG. 5. The shield member 60 can move between its retractive position shown in FIG. 4 and a shield position shown in FIG. 5.

The controller 80 varies the position of the shield member 60 according to the position of the nozzle 42. In particular, when instructing the nozzle support mechanism 50 to move the nozzle 42 from the deposition position to the retractive position of the nozzle, the controller 80 causes the shield member support mechanism 70 to move the shield member 60 from its retractive position to the shield position. When instructing the nozzle support mechanism 50 to move the nozzle 42 from its retractive position to the deposition position, the controller 80 causes the shield member support mechanism 70 to move the shield member 60 to its retractive position from the shield position.

Therefore, in the FIB system 100, if the nozzle 42 is moved from the deposition position to the retractive position of the nozzle, the shield member 60 is automatically moved from its retractive position to the shield position. Furthermore, in the FIB system 100, if the nozzle 42 is moved from its retractive position to the deposition position, the shield member 60 is automatically moved from the shield position to the retractive position of the shield member. The operation of the FIB system 100 is hereinafter described in further detail.

### 1.3.2. Film Deposition

When a film is deposited using the gas ejector 40 as shown in FIG. 4, the nozzle 42 is placed at a deposition position where the nozzle 42 can blow the gas 2 from its blowoff port 41 against the sample S. Since the nozzle 42 is located at the deposition position, the blowoff port 41 is placed close to the sample S. For example, if the nozzle 42 is placed at the deposition position, the distance between the blowoff port 41 and the surface of the sample S is on the order of tens to hundreds of micrometers.

When the nozzle 42 is placed at the deposition position, the shield member 60 is placed at its retractive position that does not lie between the blowoff port 41 and the sample S. When the shield member 60 is at its retractive position, the shield member 60 does not intersect the line segment L that connects the center of the blowoff port 41 and the intersection point P0. Therefore, if the shield member 60 is placed at its retractive position, the shield member 60 does not impede the flow of the gas 2 blown out of the blowoff port 41.

Under the condition where the nozzle 42 is at the deposition position, the valve 46 is opened as shown in FIG. 2. As a result, the gas 2 is blown from the blowoff port 41. Consequently, the gas 2 can be blown against the surface of the sample S and thus a film can be deposited on the surface of the sample S. When the valve 46 is closed as shown in FIG. 3, the supply of the gas 2 from the reservoir tank 44 to the nozzle 42 is cut off.

### 1.3.3. Retraction of Nozzle

When the nozzle 42 is retracted after a film has been deposited, the user instructs the controller 80 to retract the nozzle 42. In response, the controller 80 causes the nozzle support mechanism 50 to move the nozzle 42 linearly from the deposition position of FIG. 4 to the retractive position of the nozzle shown in FIG. 5.

When the nozzle 42 is in its retractive position, the nozzle 42 is sufficiently remote from the sample S. The distance between the blowoff port 41 and the sample S as taken when the nozzle 42 is in its retractive position as shown in FIG. 5 is greater than the distance between the blowoff port 41 and the sample S as taken when the nozzle 42 is in the deposition position as shown in FIG. 4. By bringing the nozzle 42 into its retractive position, effective use of space around the sample S can be made.

After instructing the nozzle support mechanism 50 to move the nozzle 42 from the deposition position to the retractive position of the nozzle, the controller 80 causes the shield member support mechanism 70 to move the shield member 60 from its retractive position of FIG. 4 to the shield position of FIG. 5.

The shield position is located between the blowoff port 41 and the sample S supported on the sample stage 30. When the shield member 60 is placed in the shield position, the shield member 60 intersects the line segment L that connects the center of the blowoff port 41 and the intersection point P0.

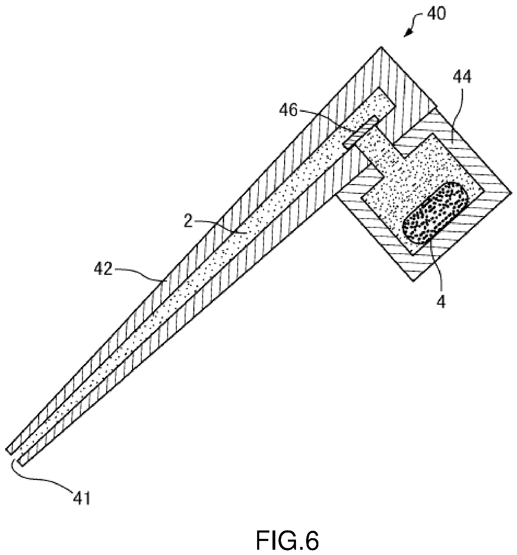

FIG. 6 is a schematic cross-sectional view of the gas ejector 40 when the valve 46 is closed after blowing the gas 2 against the sample S. As shown, the nozzle 42 is thin and long and so if the valve 46 is closed, the gas 2 will remain in the nozzle 42. If the remaining gas 2 leaks out of the nozzle 42 and reaches the surface of the sample S, a film will be deposited unintentionally on the surface of the sample S. Especially, in a cryo-FIB process, a film is deposited without electron or ion beam irradiation. Therefore, the gas 2 leaking from the nozzle 42 produces a film deposited on the surface of the sample S to such a large thickness that observation and analysis using an electron microscope may be adversely affected. Furthermore, even if the sample S is at room temperature, a thick film may be deposited on the surface of the sample S depending on the species of the gas 2.

In the FIB system 100, when the nozzle 42 is moved to its retractive position, the shield member 60 moves to the shield position as described above. Therefore, the shield member 60 can impede the flow of the gas 2 going toward the sample S after leaking from the nozzle 42.

The degree of vacuum in the sample chamber 102 is in the molecular flow region on the order of 10⁻⁵ to 10⁻⁶ Pa. In this region, gas molecules travel nearly straight. Therefore, gas molecules colliding with the shield member 60 after being ejected from the blowoff port 41 are scattered within the sample chamber 102 without going around the shield member 60. Accordingly, the placement of the shield member 60 between the blowoff port 41 and the sample S almost fully eliminates gas molecules going from the blowoff port 41 toward the sample S. Therefore, there are very few gas molecules which collide with the wall of the sample chamber 102 and reach the sample S after colliding with the shield member 60. Therefore, in the FIB system 100, the amount of gas reaching the sample S after leaking from the nozzle 42 can be reduced. Consequently, it can be prevented that a film is deposited on the surface of the sample S to such a thickness that observation and analysis using an electron microscope are adversely affected.

### 1.3.4. Insertion of Nozzle

Where the nozzle 42 is inserted in order to deposit a film on the sample S, the user instructs the controller 80 to insert the nozzle 42. In response, the controller 80 causes the shield member support mechanism 70 to move the shield member 60 from the shield position (FIG. 5) to the retractive position (FIG. 4) of the shield member. Then, the controller 80 causes the nozzle support mechanism 50 to move the nozzle 42 from the retractive position (FIG. 5) of the nozzle to the deposition position (FIG. 4). Consequently, a film can be deposited.

### 1.4. Advantageous Effects

The focused ion beam (FIB) system 100 includes: the FIB column 20 through which the ion beam is directed at the sample S; the nozzle 42 for blowing the gas 2 from the blowoff port 41 against the sample S to deposit a film; the sample stage 30 providing mechanical support of the sample S; the shield member 60 for impeding the flow of the gas 2, the shield member 60 being movable to the shield position located between the blowoff port 41 and the sample S supported on the stage 30, the shield member 60 being also movable to its retractive position not located between the blowoff port 41 and the sample S on the sample stage 30; and the shield member support mechanism 70 by which the shield member 60 is supported such that it can move between the shield position and the retractive position of the shield member.

Therefore, in the FIB system 100, if the nozzle 42 is not used, the shield member 60 can be disposed between the blowoff port 41 and the sample S. This can reduce the amount of gas leaking from the nozzle 42 and reaching the sample S. Consequently, in the FIB system 100, it can be prevented unintentionally that a film is deposited on the surface of the sample S so thickly that observation and analysis using an electron microscope are adversely affected.

The FIB system 100 includes: the nozzle support mechanism 50 for supporting the nozzle 42 so that it can move between the deposition position at which the gas 2 is blown against the sample S from the blowoff port 41 and the retractive position of the nozzle different from the deposition position; and the controller 80 for controlling the nozzle support mechanism 50 and the shield member support mechanism 70. When the nozzle support mechanism 50 is instructed to move the nozzle 42 from the deposition position to the retractive position of the nozzle, the controller 80 causes the shield member support mechanism 70 to move the shield member 60 from its retractive position to the shield position. Therefore, in the FIB system 100, when the nozzle 42 is moved from the deposition position to the retractive position of the nozzle, the shield member 60 automatically moves from its retractive position to the shield position. Consequently, with the FIB system 100, it can be prevented that a film is deposited thickly on the surface of the sample S without user's consciousness.

In the FIB system 100, when the nozzle support mechanism 50 is instructed to move the nozzle 42 from its retractive position to the deposition position, the controller 80 causes the shield member support mechanism 70 to move the shield member 60 from the shield position to the retractive position of the shield member. Therefore, in the FIB system 100, if the nozzle 42 is moved from its retractive position to the deposition position, the shield member 60 is automatically moved from the shield position to the retractive position of the shield member. Consequently, with the FIB system 100, it can be prevented unintentionally that a film is deposited thickly on the surface of the sample S.

The FIB system 100 includes the cooling mechanism 32 for cooling the sample stage 30. In the FIB system 100, if the nozzle 42 is not used, the shield member 60 can be placed between the blowoff port 41 and the sample S. Therefore, if the FIB system 100 is a cryo-FIB system which mills the sample S while cooling it, it can be prevented without user's consciousness that a film is deposited thickly on the surface of the sample S.

The FIB system 100 includes the reservoir tank 44 that contains the gas source 4 producing the gas 2 and the valve 46 mounted between the nozzle 42 and the reservoir tank 44. The gas 2 is supplied from the reservoir tank 44 into the nozzle 42 by opening the valve 46. In the FIB system 100, if the nozzle 42 is not used, the shield member 60 is positioned between the blowoff port 41 and the sample S. Therefore, when the valve 46 is closed, the amount of gas reaching the sample S after leaking from the nozzle 42 can be reduced.

### 1.5. Modifications

### 1.5.1. First Modification

In the first embodiment described above, the controller 80 varies the position of the shield member 60 by controlling the shield member support mechanism 70 according to the position of the nozzle 42. The processing of the controller 80 is not restricted to this operation. For example, the controller 80 may vary the position of the shield member 60 by controlling the shield member support mechanism 70 in response to an instruction by a user. That is, if an instruction for moving the shield member 60 to the shield position is accepted from a user, the controller 80 causes the shield member support mechanism 70 to move the shield member 60 to the shield position. Also, if an instruction for moving the shield member 60 to its retractive position is accepted from a user, the controller 80 causes the shield member support mechanism 70 to move the shield member 60 to its retractive position.

### 1.5.2. Second Modification

In the first embodiment described above, the controller 80 controls the shield member support mechanism 70 to vary the position of the shield member 60. Alternatively, a user may vary the position of the shield member 60 by manually manipulating the shield member support mechanism 70. In this case, the support mechanism 70 has no driver device, for example. The user may manually move the shield member 60 via a mechanical element such as a shaft connected to the shield member 60.

Also, in the first embodiment, the controller 80 controls the nozzle support mechanism 50 to vary the position of the nozzle 42. The user may vary the position of the nozzle 42 by manually manipulating the nozzle support mechanism 50. In this case, the nozzle support mechanism 50 has no driver device, for example. The user may manually move the nozzle 42 via a mechanical element such as a shaft connected to the nozzle 42.

### 1.5.3. Third Modification

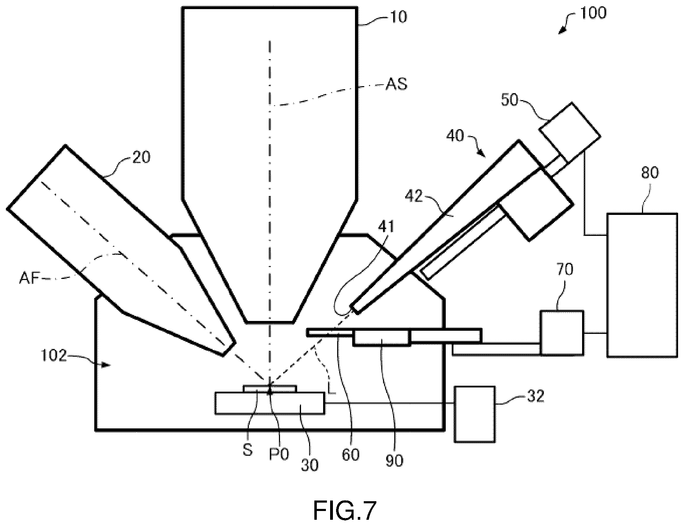

FIG. 7 shows a modification of the FIB system 100, the modification including a detector 90 for detecting electrons emitted from the sample S in response to irradiation of the sample S with an electron beam. In this FIB system 100 associated with the third modification, the shield member 60 is connected to the detector 90.

For example, the detector 90 is a backscattered electron detector for detecting backscattered electrons emanating from the sample S. In the FIB system 100, the SEM column 10 scans the sample S with an electron probe. Backscattered electrons emanating from the sample S are detected by the detector 90. As a result, a backscattered electron image can be obtained.

The shield member 60 and the detector 90 are movably supported by the shield member support mechanism 70. That is, the shield member support mechanism 70 also acts as a detector support mechanism movably supporting the detector 90 and so the parts count can be reduced. When backscattered electrons are detected by the detector 90, the shield member support mechanism 70 brings the detector 90 just under the SEM column 10 capable of detecting backscattered electrons. When backscattered electrons are not detected by the detector 90, the shield member support mechanism 70 moves the detector 90 to its retractive position shown in FIG. 7, the retractive position being set remotely from the sample S.

The detector 90 to which the shield member 60 is connected is not restricted to a backscattered electron detector. Rather, any detector that detects signals emanating from the sample S can be used. For example, the detector 90 may be an X-ray detector for detecting characteristic X-rays emitted from the sample S or an EBSD detector for producing EBSD (electron backscatter diffraction).

The member to which the shield member 60 is connected is not restricted to a detector but rather any other member disposed in the sample chamber 102 may also be available. For example, the shield member 60 may be connected to a manipulator for picking up a section cut out of the sample S. The shield member 60 and the manipulator may be movably supported by the shield member support mechanism 70.

### 1.5.4. Fourth Modification

In the foregoing first embodiment, the controller 80 operates the shield member support mechanism 70 in response to the operation of the nozzle support mechanism 50. Alternatively, the shield member support mechanism 70 may be so configured that the operation of the shield member support mechanism 70 mechanically links with the operation of the nozzle support mechanism 50. That is, when the nozzle support mechanism 50 moves the nozzle 42 from the deposition position to the retractive position of the nozzle, the shield member support mechanism 70 may move the shield member 60 from its retractive position to the shield position in a mechanical interlocking manner with the operation of the nozzle support mechanism 50. Similarly, when the nozzle support mechanism 50 moves the nozzle 42 from its retractive position to the deposition position, the shield member support mechanism 70 may move the shield member 60 from the shield position to the retractive position of the shield member in a mechanical interlocking manner with the operation of the nozzle support mechanism 50.

In this way, the shield member support mechanism 70 moves the shield member 60 between the shield position and the retractive position of the shield member in a mechanical interlocking manner with the movement of the nozzle 42. Consequently, it can be prevented without user's consciousness that a film is deposited thickly on the surface of the sample S.

### 2. Second Embodiment

### 2.1. Focused Ion Beam System

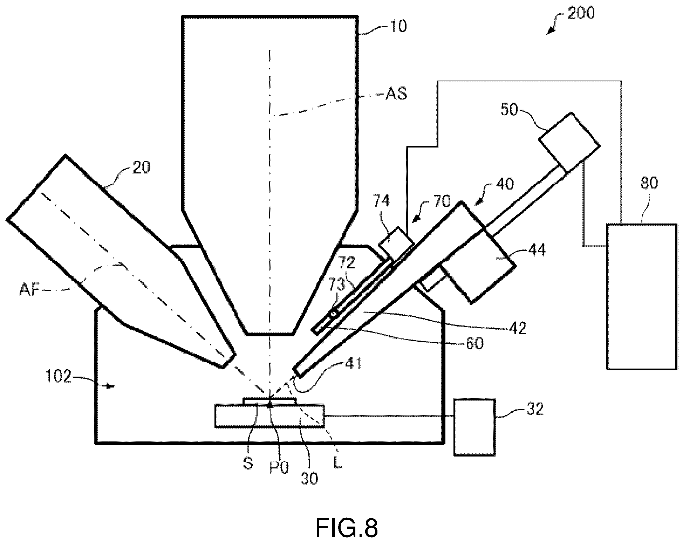

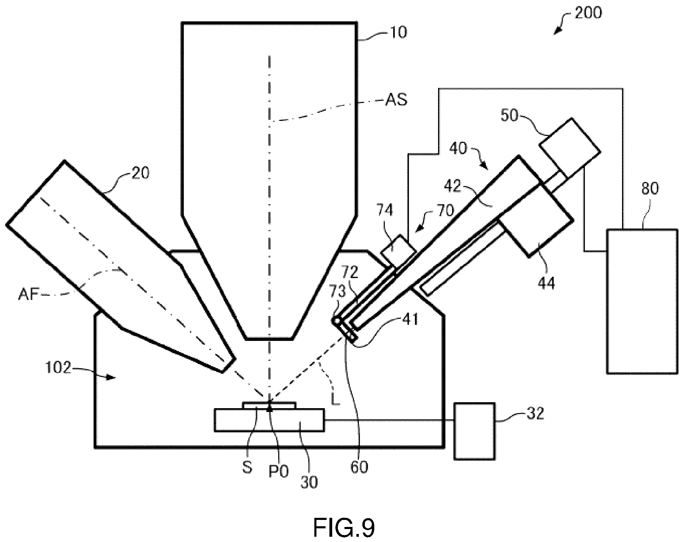

A focused ion beam (FIB) system associated with a second embodiment is next described by referring to FIGS. 8 and 9 which show the configuration of the FIB system, 200, associated with the second embodiment. Note that FIGS. 8 and 9 correspond to FIGS. 4 and 5, respectively. Those members of the FIB system 200 which are similar in function to their respective counterparts of the FIB system 100 associated with the first embodiment are hereinafter indicated by the same reference numerals as in the foregoing figures and a detailed description thereof is omitted.

As shown in FIGS. 8 and 9, in the FIB system 200, the shield member 60 is a cover in the form of a flat plate that plugs the blowoff port 41 of the nozzle 42.

The shield member support mechanism 70 includes a support member 72 providing mechanical support of the shield member 60, a shaft member 73 by which the shield member 60 is rotatably connected to the support member 72, and a driver device 74 for rotating the shield member 60 around the shaft member 73. In the shield member support mechanism 70, the shield member 60 can be moved between a shield position (FIG. 9) and a retractive position (FIG. 8) of the shield member by rotating the shield member 60 around the shaft member 73 by means of the driver device 74.

By bringing the shield member 60 into its retractive position as shown in FIG. 8, the cover made of the shield member 60 plugging the blowoff port 41 can be opened. The blowoff port 41 can be covered by placing the shield member 60 into the shield position as shown in FIG. 9.

The nozzle 42 is supported by the nozzle support mechanism 50. The shield member 60 is supported by the shield member support mechanism 70. Since the nozzle 42 and the shield member 60 are supported by separate members in this way, if the nozzle 42 is moved into the deposition position, the shield member 60 can be placed in its retractive position remote from the sample S. Accordingly, in the FIB system 200, effective use can be made of the space in the vicinity of the sample S.

### 2.2. Operations

### 2.2.1. Operations of Nozzle and Shield Member

The differences of the operations of the focused ion beam (FIB) system 200 from the operations of the above-described FIB system 100 are described below. A description of similarities is omitted.

### 2.2.2. Deposition of Film

Where a film is deposited using the gas ejector 40 as shown in FIG. 8, the nozzle 42 is placed in the deposition position where the gas 2 is blown from the blowoff port 41 against the sample S. Under the condition where the nozzle 42 is in the deposition position, the valve 46 is opened as shown in FIG. 2. As a result, a film can be deposited on the surface of the sample S. At this time, the shield member 60 is in its retractive position and so the shield member 60 is switched from closed state (i.e., plugging up the blowoff port 41) to open state. Under this condition, the flow of the gas 2 blown out from the shield member 60 through its blowoff port 41 is not impeded.

### 2.2.3. Retraction of Nozzle

When an instruction for retracting the nozzle 42 is accepted, the controller 80 causes the nozzle support mechanism 50 to move the nozzle 42 from the deposition position to the retractive position of the nozzle as shown in FIG. 9. Then, the controller 80 causes the shield member support mechanism 70 to move the shield member 60 from its retractive position to the shield position. Consequently, the blowoff port 41 can be covered by the shield member 60. This can impede the flow of the gas 2 which goes toward the sample S after leaking out from the nozzle 42.

### 2.3. Advantageous Effects

In the FIB system 200, when the nozzle 42 is not used, the shield member 60 can be positioned between the blowoff port 41 and the sample S in the same manner as in the foregoing FIB system 100. Therefore, with the FIB system 200, it can be prevented unintentionally that a film is deposited on the surface of the sample S so thickly that observation and analysis using an electron microscope are adversely affected.

### 2.4. Modifications

In the foregoing second embodiment, the controller 80 operates the shield member support mechanism 70 in response to the operation of the nozzle support mechanism 50. The shield member support mechanism 70 may be so configured as to operate in a mechanical interlocking manner with the operation of the nozzle support mechanism 50 in the same manner as in the fourth modification of the first embodiment.

For example, the shield member support mechanism 70 may include a biasing member such as a spring for maintaining the shield member 60 at the shield position. When the nozzle 42 is moved from its retractive position to the deposition position, the front end of the nozzle 42 pushes against the shield member 60 so that the shield member 60 moves from the shield position to the retractive position of the shield member, thus opening the cover closing off the blowoff port 41. When the nozzle 42 is moved from the deposition position to the retractive position of the nozzle, the biasing member biases the shield member 60 back into the shield position from the retractive position of the shield member, thus providing a cover over the blowoff port 41.

The first and second modifications of the first embodiment are also applicable to the focused ion beam system 200 associated with the second embodiment.

### 3. Third Embodiment

### 3.1. Focused Ion Beam System

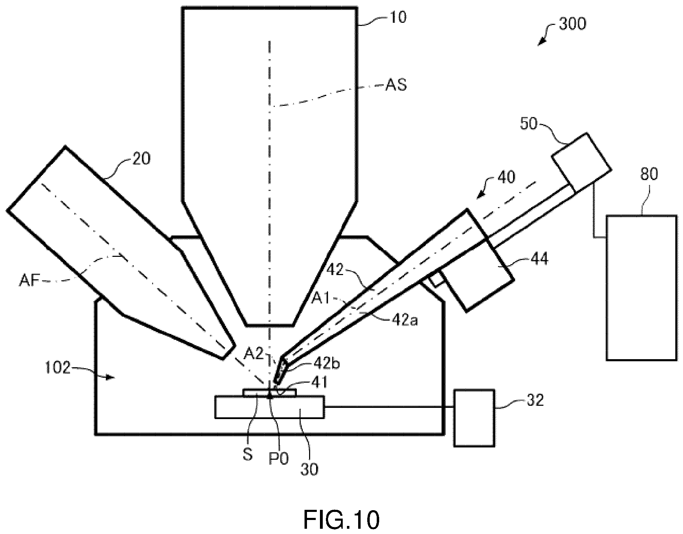

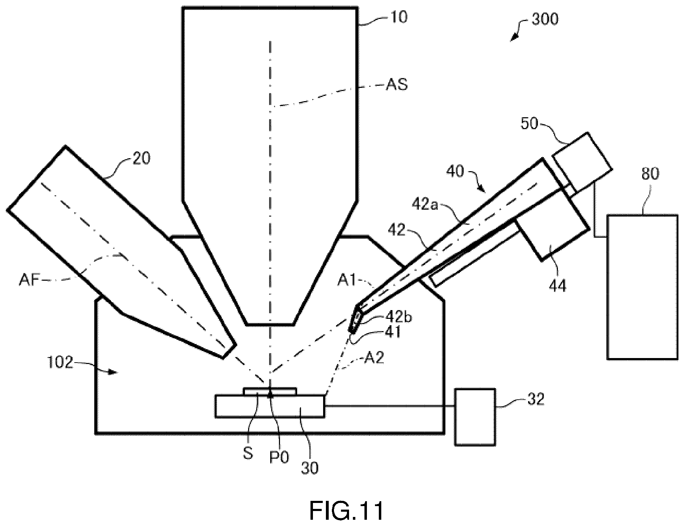

A focused ion beam (FIB) system associated with a third embodiment is next described by referring to FIGS. 10 and 11, which show the configuration of the FIB system, 300, associated with the third embodiment. FIGS. 10 and 11 correspond to FIGS. 4 and 5, respectively. Those members of the FIB system 300 which are similar in function to their respective counterparts of the FIB system 100 associated with the first embodiment are hereinafter indicated by the same reference numerals as in the foregoing figures and a detailed description thereof is omitted.

In the above-described FIB system 100, the amount of the gas 2 reaching the sample S after leaking from the nozzle 42 is reduced by placing the shield member 60 between the blowoff port 41 and the sample S as shown in FIG. 5.

In contrast, in the FIB system 300, as shown in FIGS. 10 and 11, the amount of the gas 2 reaching the sample S after leaking from the nozzle 42 is reduced by moving the nozzle 42 so that the blowoff port 41 faces away from the sample S.

It is possible to effect a switch between an operable state in which the blowoff port 41 faces towards the sample S as shown in FIG. 10 and thus a film can be deposited and a retracted state in which the blowoff port 41 faces away from the sample S as shown in FIG. 11, by causing the nozzle support mechanism 50 to move the nozzle 42 between the deposition position and the retractive position of the nozzle. In this way, the nozzle support mechanism 50 acts as a switching mechanism for effecting a switch between the operable state in which a film can be deposited and the retracted state.

The nozzle 42 has a first portion 42a and a second portion 42b which are connected together. The second portion 42b has the blowoff port 41 at its front end. The first portion 42a and the second portion 42b have central axes A1 and A2, respectively, which are tilted relative to each other. That is, the nozzle 42 is bent at the joint between the first portion 42a and the second portion 42b. The second portion 42b is shorter in length than the first portion 42a.

The nozzle support mechanism 50 moves the nozzle 42 rectilinearly along the central axis A1 relative to which the central axis A2 of the second portion 42b is tilted. This causes the nozzle 42 to face away from the blowoff port 41. Therefore, it is possible to effect a switch between the operable state in which a film can be deposited and the retracted state.

In the operable state, the blowoff port 41 faces towards the sample S along the central axis A2. Where the surface of the sample S and the central axis A2 intersect with each other, the blowoff port 41 faces towards the sample S. In the operable state, the central axis A2 intersects the surface of the sample S, and the gas 2 blown out from the blowoff port 41 flows toward the sample S. Consequently, a film can be deposited on the surface of the sample S.

In the retracted state, the blowoff port 41 faces away from the sample S and the central axis A2 of the second portion 42b does not intersect the surface of the sample S. In the molecular flow region, gas molecules travel nearly straight and so, in the retracted state, the gas 2 blown out of the blowoff port 41 flows in directions not directed toward the sample S. Therefore, in the retractive state, the amount of the gas 2 reaching the sample S after leaking from the nozzle 42 can be reduced as compared to in the operable state.

### 3.2. Operations

### 3.2.1. Operations of Nozzle and Shield Member

With respect to the operations of the focused ion beam system 300, the differences with the operations of the above-described focused ion beam system 100 are hereinafter described. A description of similarities is omitted.

### 3.2.2. Deposition of a Film

Where a film is deposited using the gas ejector 40, the nozzle 42 is placed at the deposition position as shown in FIG. 10. In this operable state, the blowoff port 41 of the nozzle 42 faces towards the sample S and thus a film can be deposited.

In the operable state, the valve 46 is opened as shown in FIG. 2. As a result, the gas 2 is blown out of the blowoff port 41. Consequently, the gas 2 can be blown against the surface of the sample S. Thus, a film can be deposited on the surface of the sample S.

### 3.2.3. Retraction of Nozzle

Upon accepting an instruction to retract the nozzle 42, the controller 80 causes the nozzle support mechanism 50 to move the nozzle 42 from the deposition position to the retractive position of the nozzle, at which the blowoff port 41 of the nozzle 42 faces away from the sample S as shown in FIG. 11, resulting in a retracted state. In consequence, the amount of the gas 2 reaching the sample S after leaking from the nozzle 42 can be reduced.

### 3.2.4. Insertion of Nozzle

Upon accepting an instruction to insert the nozzle 42, the controller 80 causes the nozzle support mechanism 50 to move the nozzle 42 from its retractive position to the deposition position, whereby the blowoff port 41 of the nozzle 42 faces towards the sample S as shown in FIG. 10 and thus a film can be deposited.

### 3.3. Advantageous Effects

The focused ion beam (FIB) system 300 includes the nozzle support mechanism 50 acting as a switching mechanism for effecting a switch between the operable state in which the blowoff port 41 of the nozzle 42 faces towards the sample S and thus a film can be deposited and the retracted state in which the blowoff port 41 faces away from the sample S. Therefore, in the FIB system 300, when the nozzle 42 is not used, the retracted state in which the blowoff port 41 faces away from the sample S can be accomplished. Consequently, with the FIB system 300, it can be prevented unintentionally that a film is deposited on the surface of the sample S so thickly that observation and analysis using an electron microscope are adversely affected, in the same manner as for the FIB system 100.

In the FIB system 300, the nozzle support mechanism 50 acting as a switching mechanism moves the nozzle 42, whereby enabling to effect a switch between the operable state in which a film can be deposited and the retracted state. Accordingly, the FIB system 300 does not need to use the shield member 60 unlike the FIB system 100 and so the parts count can be reduced.

### 3.4. Modification

In the third embodiment described above, the controller 80 controls the nozzle support mechanism 50 to vary the position of the nozzle 42. Alternatively, the user may vary the position of the nozzle 42 by manually manipulating the nozzle support mechanism 50.

### 4. Fourth Embodiment

### 4.1. Focused Ion Beam System

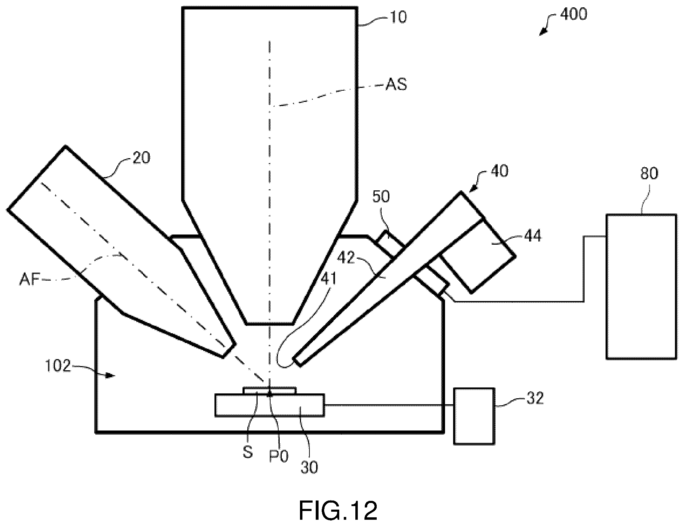

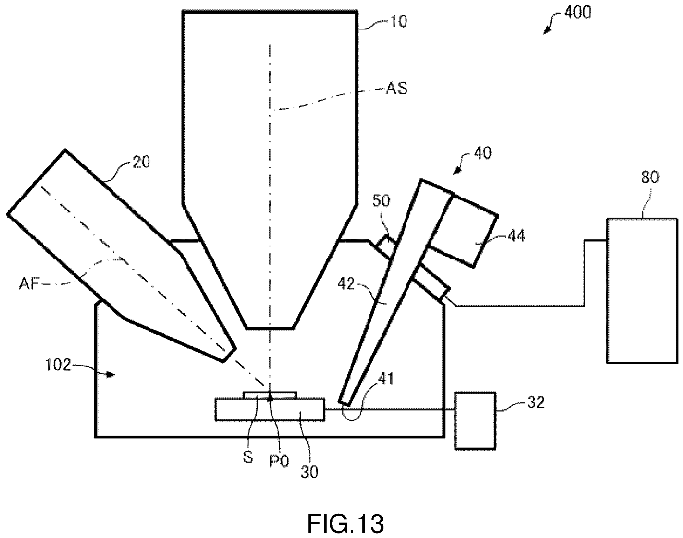

A focused ion beam (FIB) system associated with a fourth embodiment is next described by referring to FIGS. 12 and 13, which show the configuration of the FIB system, 400, associated with the fourth embodiment. FIGS. 12 and 13 correspond to FIGS. 4 and 5, respectively. Those members of the FIB system 400 which are similar in function to their respective counterparts of the FIB systems 100 and 300 associated with the first and third embodiments are indicated by the same reference numerals as in the foregoing figures and a detailed description thereof is omitted.

In the FIB system 300 described above, as shown in FIGS. 10 and 11, a switch is effected between the operable state in which a film can be deposited and the retracted state by moving the nozzle 42 by means of the nozzle support mechanism 50 acting as a switching mechanism. In the FIB system 400, on the other hand, the nozzle support mechanism 50 acting as a switching mechanism rotates the nozzle 42 to switch between the operable state shown in FIG. 12 and the retracted state shown in FIG. 13.

The nozzle support mechanism 50 rotationally moves the nozzle 42 and includes, for example, a shaft member by which the nozzle 42 is rotatably supported and a driver device such as an electric motor. The nozzle 42 is rotated around the shaft member by power from the driver device.

The nozzle 42 is tilted by rotationally moving it and thus the blowoff port 41 can be varied in sense. Consequently, a switch can be effected between the operable state in which the blowoff port 41 faces towards the sample S and thus a film can be deposited and the retracted state in which the port 41 faces away from the sample S.

In the example of FIGS. 12 and 13, the nozzle 42 is in the form a straight cylinder but the nozzle 42 may be bent as shown in FIGS. 10 and 11.

### 4.2. Operation

The operation of the focused ion beam system 400 is similar to the operation of the above-described focused ion beam system 300 except that the nozzle support mechanism 50 rotates the nozzle 42 and so a description thereof is omitted.

### 4.3. Advantageous Effects

In the FIB system 400, the nozzle support mechanism 50 acting as the switching mechanism moves the nozzle 42 and thus a switch can be effected between the operable state in which a film can be deposited and the retracted state. Accordingly, with the FIB system 400, it can be prevented unintentionally that a film is deposited on the surface of the sample S thickly, in the same manner as for the FIB system 100. Moving the nozzle 42 involves moving the nozzle 42 rectilinearly as shown in FIGS. 10 and 11 and rotationally moving the nozzle 42 as shown in FIGS. 12 and 13.

### 4.4. Modification

In the example illustrated in FIGS. 12 and 13, the nozzle support mechanism 50 rotates the nozzle 42 and the reservoir tank 44 together. Alternatively, the nozzle support mechanism 50 may rotate only the nozzle 42 in a manner not illustrated. This can be implemented, for example, by connecting together the reservoir tank 44 and the nozzle 42 via a deformable member such as a resinous tube or a metal bellows.

The nozzle support mechanism 50 may move the nozzle 42 by utilizing a combination of the rotational movement of the nozzle 42 as illustrated in FIGS. 12 and 13 and the linear movement of the nozzle 42 as illustrated in FIGS. 4 and 5.

### 5. Fifth Embodiment

### 5.1. Focused Ion Beam System

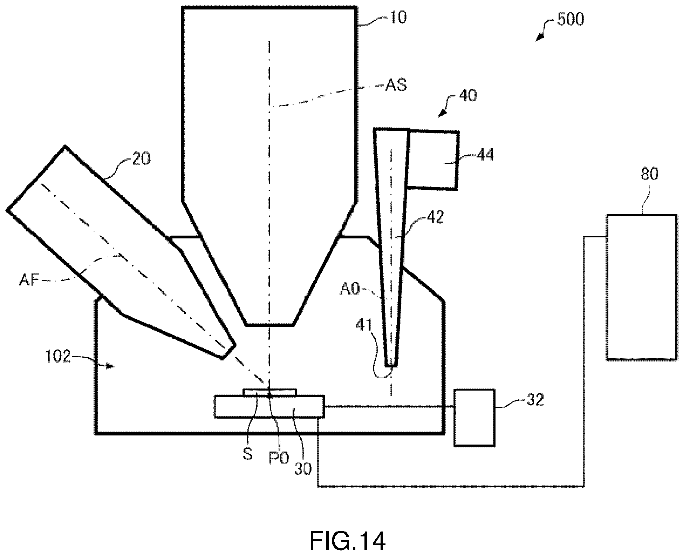

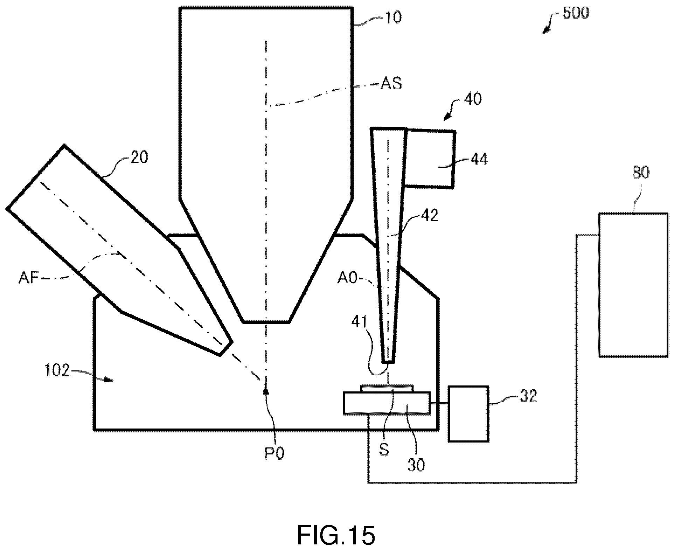

A focused ion beam (FIB) system associated with a fifth embodiment is next described by referring to FIGS. 14 and 15 which show the configuration of the FIB system, 500, associated with the fifth embodiment. FIGS. 14 and 15 correspond to FIGS. 4 and 5, respectively. Those members of the FIB system 500 which are similar in function to their respective counterparts of the FIB systems 100, 300, and 400 associated with the first, third, and fourth embodiments, respectively, are indicated by the same reference numerals as in the foregoing figures and a detailed description thereof is omitted.

In the above-described FIB systems 300 and 400, a switch is effected between the operable state in which a film can be deposited and the retracted state by moving the nozzle 42. In contrast, in the FIB system 500, the sample S is moved to switch between the operable state of FIG. 15 and the retracted state of FIG. 14.

In the FIB system 500, the nozzle 42 is fixed and located such that the blowoff port 41 faces away from the intersection point P0. For example, the nozzle 42 is so located that the blowoff port 41 faces downward, and the nozzle 42 is positioned remotely from the intersection point P0.

The sample stage 30 moves the sample S between a milling position being the intersection point P0 shown in FIG. 14 and the deposition position at which the surface of the sample S intersects with the central axis A0 of the nozzle 42 as shown in FIG. 15. The sample stage 30 moves the sample S horizontally. In the FIB system 500, the milling position where the sample S is milled and observed is different from the deposition position where a film is deposited on the sample S.

If the sample S is placed at the milling position as shown in FIG. 14, the nozzle 42 is placed into the retracted state where the blowoff port 41 faces away from the sample S. Therefore, the amount of the gas 2 hitting the sample S after leaking from the nozzle 42 can be reduced. If the sample S is placed at the deposition position as shown in FIG. 15, the nozzle 42 is placed into the operable state in which the blowoff port 41 faces towards the sample S. Under this condition, therefore, a film can be deposited on the surface of the sample S. In this way, the sample stage 30 acts as a switching mechanism for effecting a switch between the operable state and the retracted state.

### 5.2. Operations

### 5.2.1. Operations of Nozzle and Shield Member

With respect to the operations of the focused ion beam system 500, differences with the operations of the above-described FIB system 100 are hereinafter set forth; a description of similarities is omitted.

### 5.2.2. Deposition of Film

Where a film is deposited using the gas ejector 40, the sample S is placed at the deposition position as shown in FIG. 15. Under this condition, the blowoff port 41 of the nozzle 42 faces towards the sample S and thus a film can be deposited. In this state, the valve 46 is opened as shown in FIG. 2, so that the gas 2 is blown out from the blowoff port 41. Consequently, the gas 2 can be blown against the surface of the sample S. Because the sample S is being cooled by the sample stage 30, a film can be deposited on the surface of the sample S by the blowing of the gas 2 without irradiating the sample with an electron beam or an ion beam.

### 5.2.3. Milling and Observation

Where milling and observation are effected after a film is deposited, the user instructs the controller 80 to move the sample S into the milling position. Upon accepting this instruction, the controller 80 causes the sample stage 30 to move the sample S from the deposition position of FIG. 15 to the milling position of FIG. 14. This places the sample S into the intersection point P0, whereby milling and observation of the sample S are possible.

Furthermore, placing the sample S into the milling position causes the blowoff port 41 of the nozzle 42 to face away from the sample S. In this retracted state, the amount of the gas 2 reaching the sample S after leaking from the nozzle 42 can be reduced because the blowoff port 41 does not face towards the sample S. Accordingly, if neither milling nor observation is made, for example, the amount of the gas 2 reaching the sample S after leaking from the nozzle 42 can be reduced by placing the sample S into the milling position.

### 5.2.4. Movement into Deposition Position

When the sample S is moved into the deposition position, the user instructs the controller 80 to move the sample S into the deposition position. Upon accepting the instruction, the controller 80 causes the sample stage 30 to move the sample S from the milling position of FIG. 14 to the deposition position of FIG. 15, whereby the blowoff port 41 of the nozzle 42 faces towards the sample S. In consequence, a film can be deposited on the surface of the sample S.

### 5.3. Advantageous Effects

In the focused ion beam (FIB) system 500, the sample stage 30 acting as a switching mechanism moves the sample S, thus effecting a switch between the operable state in which a film can be deposited and the retracted state. Consequently, with the FIB system 500, it can be prevented unintentionally that a film is deposited thickly on the surface of the sample S in the same way as for the FIB system 100.

In the FIB system 500, the nozzle 42 is fixed and so a mechanism for moving the nozzle 42 is dispensed with unlike the FIB system 100. Hence, the parts count can be reduced.

### 6. Others

It is to be understood that the present invention is not restricted to the foregoing embodiments but rather can be implemented in variously modified forms without departing from the gist of the present invention.

In the above-described first embodiment, the focused ion beam system 100 is equipped with both SEM column 10 and FIB column 20. The FIB system 100 does not need to have the SEM column 10. Similarly, the FIB systems associated with the second through fifth embodiments may not need to have the SEM column 10.

The above-described embodiments and modifications are merely exemplary and the present invention is not restricted thereto. For example, the embodiments and modifications can be combined appropriately.

The present invention is not restricted to the foregoing embodiments but rather implemented in variously modified forms. For example, the present invention embraces configurations (e.g., configurations identical in function and method) which are substantially identical to the configurations described in the above embodiments. Furthermore, the invention embraces configurations which are similar to the configurations described in the above embodiments except that their nonessential portions have been replaced. Further, the invention embraces configurations which are similar to the configurations described in any one of the above embodiments except that a well-known technique is added.

## Claims

1. A focused ion beam system for milling a sample by irradiating the sample with an ion beam, said focused ion beam system comprising:
an ion beam column through which the ion beam is directed at the sample;
a nozzle having a blowoff port for blowing a gas against the sample to deposit a film;
a sample stage providing mechanical support of the sample;
a shield member for impeding the flow of the gas, the shield member being movable to a shield position that is located between the blowoff port and the sample supported on the sample stage, the shield member being also movable to its retractive position not located between the blowoff port and the sample supported on the sample stage; and
a shield member support mechanism for supporting the shield member so that the shield member can move between the shield position and the retractive position of the shield member.

2. A focused ion beam system as set forth in claim 1, further comprising:
a nozzle support mechanism by which said nozzle is supported so as to be movable between a deposition position at which said gas from said blowoff port can be blown against the sample and a retractive position of the nozzle different from the deposition position; and
a controller for controlling the nozzle support mechanism and the shield member support mechanism;
wherein, when the nozzle support mechanism is caused to move the nozzle from the deposition position to the retractive position of the nozzle, the controller causes the shield member support mechanism to move the shield member from its retractive position to the shield position.

3. A focused ion beam system as set forth in claim 2, wherein, when said nozzle support mechanism is caused to move the nozzle from its retractive position to the deposition position, said controller causes said shield member support mechanism to move said shield member from the shield position to the retractive position of the shield member.

4. A focused ion beam system as set forth in claim 1, further comprising a nozzle support mechanism by which said nozzle is movably supported, and wherein said shield member support mechanism moves said shield member between said shield position and said retractive position of the shield member in a mechanical interlocking manner with movement of the nozzle.

5. A focused ion beam system as set forth in claim 1, further comprising a detector for detecting a signal emitted from said sample, and wherein said shield member is connected to the detector.

6. A focused ion beam system for milling a sample by irradiating the sample with an ion beam, said focused ion beam system comprising:
an ion beam column through which the ion beam is directed at the sample;
a nozzle having a blowoff port from which a gas for depositing a film is blown against the sample;
a sample stage providing mechanical support of the sample; and
a switching mechanism for effecting a switch between an operable state in which the blowoff port faces towards the sample and a film can be deposited and a retracted state in which the blowoff port faces away from the sample.

7. A focused ion beam system as set forth in claim 6, wherein said switching mechanism effects a switch between said operable state and said retracted state by moving said nozzle.

8. A focused ion beam system as set forth in claim 7, wherein said nozzle is bent.

9. A focused ion beam system as set forth in claim 6, wherein said sample is movably supported by said sample stage, and wherein said switching mechanism effects a switch between said operable state and said retracted state by moving the sample.

10. A focused ion beam system as set forth in any one of claims 1 to 9, further comprising a cooling mechanism for cooling said sample stage.

11. A focused ion beam system as set forth in any one of claims 1 to 10, further comprising:
a tank containing a gas source that produces said gas; and
a valve mounted between said nozzle and the tank;
wherein the gas is supplied from the tank into the nozzle by opening the valve.
